# EUROPÄISCHE PATENTSCHRIFT

(11) **EP 3 379 693 B1**
(45) Veröffentlichungstag und Bekanntmachung des Hinweises auf die Patenterteilung: **23.10.2019**
(21) Anmeldenummer: 17162035.4
(22) Anmeldetag: 21.03.2017
(51) Int. Cl.: H02J 13/00

(54) **VERFAHREN ZUR AUTOMATISCHEN PHASENERKENNUNG VON MESSWERTEN**
METHOD FOR THE AUTOMATIC PHASE DETECTION OF MEASUREMENT VALUES
PROCÉDÉ DE DÉTECTION DE PHASE AUTOMATIQUE DE VALEURS DE MESURE

(43) Veröffentlichungstag der Anmeldung: 26.09.2018
(73) Patentinhaber: Siemens Aktiengesellschaft, 80333 München (DE)
(72) Erfinder: Diwold, Konrad, 1180 Wien (AT); Aufhauser, Daniel, 3130 Herzogenburg (AT); Einfalt, Alfred, 1210 Wien (AT)
(74) Vertreter: Maier, Daniel Oliver

(56) Entgegenhaltungen:
- US-A1- 2011 161 022
- US-A1- 2014 077 970

## Beschreibung

### Technisches Gebiet

Die vorliegende Erfindung betrifft ein Verfahren zur automatischen Phasenerkennung von Messwerten. Diese Messwerte werden von Messeinheiten, welche in einem Niederspannungsnetz mit mehreren - üblicherweise drei - Phasen installiert sind, phasenspezifisch gemessen. Dabei werden die von den Messeinheiten gemessenen Messwerte mit einem Zeitstempel versehen und in regelmäßigen, zeitlichen Abständen zumindest an eine Datenkonzentrationseinheit weitergeleitet.

### Stand der Technik

Durch eine zunehmende Durchdringung mit dezentralen, meist erneuerbaren Energieerzeugungsanlagen (z.B. Photovoltaikanlagen, Windkraftanlagen, etc.) ist der klassische Betrieb von Energieversorgungsnetzen vor große Herausforderungen gestellt. Zusätzlich führen die Entwicklung der Elektromobilität und damit eine verstärkte Substitution von anderen Energieübertragungsformen durch Elektrizität zu weiteren Herausforderungen. Als Lösung werden häufig so genannte Intelligente Stromnetze (Smart Grids) gesehen. Dabei ist insbesondere durch die dezentrale Einspeisung von z.B. Wind- und/oder Sonnenenergie die Netzstabilität gefährdet.

Die Gefährdung der Netzstabilität kann vorwiegend in zwei Bereichen auftreten. In Versorgungsnetzen im ländlichen Raum ist das vorherrschende Problem die Spannungserhaltung bzw. das so genannte U-Problem. Bei Versorgungsnetzen im urbanen Bereich, welche aufgrund der Lastdichte eher geringe Leitungslängen aufweisen, ist weniger die Spannungserhaltung, sondern vielmehr eine Auslastung der Betriebsmittel das vorherrschende Problem, welches auch als so genannten I-Problem bezeichnet wird. Durch die dezentrale Einspeisung von Energie kann zunächst eine hohe Auslastung von Betriebsmitteln wie z.B. Leitungen und Transformatoren verringert werden. In sehr seltenen Fällen werden bei der Rückspeisung Leistungsgrenzen verletzt. Natürlich können z.B. in suburbanen Gebieten auch Netzabschnitte innerhalb eines Netzgebietes sowohl eher den beschriebenen ländlichen als auch den städtischen Charakter haben.

Um einen normgerechten Netzbetrieb - wie z.B. eine Einhalten von Spannungsgrenzen gemäß der Norm EN50160 (z.B. Spannungsgrenzen von +/- 10% der Nennspannung) - auch bei einem vom Versorgungsanschluss des Niederspannungsnetzes weit entfernten Teilnehmer aufrechtzuerhalten bzw. um eine Überlastung der Betriebsmittel zu verhindern, kann beispielsweise der Ausbau des Netzes forciert werden. Alternativ oder zusätzlich, kann ein aktives Netzmanagement eingesetzt werden, um einen normgerechten Betrieb aufrecht zu erhalten und/oder eine Überbelastung zu vermeiden. Dabei greift ein Netzmanagementsystem gezielt auf Erzeuger, flexible Verbraucher oder auch Energiespeicher im Netz zu und steuert diese beispielsweise mit einem so genannten Demand-Response Verfahren derart, dass der Netzbetrieb unter Einhaltung der Spannungsgrenzen aufrecht erhalten werden kann. Sowohl für planerische Maßnahmen des Netzausbaus als auch für einen Einsatz eines aktiven Netzmanagementsystems sind valide und korrekte Messwerte aus den betroffenen Netzen - insbesondere aus Niederspannungsnetzen - eine wesentliche Basis für wirtschaftliche Entscheidungen und/oder den stabilen Netzbetrieb.

Niederspannungsnetze sind ein Teil des Energieversorgungsnetzes, durch welche eine Verteilung der elektrischen Energie an die elektrischen Endverbraucher erfolgt. Um Spannungsverluste zu vermeiden, sind Niederspannungsnetze in der räumlichen Ausdehnung auf einen Bereich von einigen 100 m bis zu einigen wenigen Kilometern beschränkt. Sie werden regional über Transformatorstationen (Ortsnetzstationen) aus einem übergeordneten Mittelspannungsnetz gespeist. Da für die Verteilung von elektrischer Energie Wechselspannung genutzt wird, sind Versorgungsnetze wie Niederspannungsnetze üblicherweise mehrphasig, insbesondere dreiphasig, ausgeführt. Die elektrische Energie wird hierbei idealisiert über zumeist drei Außenleiter übertragen, welchen ein sinusförmiger Spannungsverlauf aufgeprägt ist, welcher um einen definierten zeitlichen Bezug phasenverschoben ist. Dabei werden üblicherweise sowohl die Außenleiter als auch die zeitlich Beziehung der ihnen aufgeprägten Spannungsverläufe als Phase bezeichnet.

Eine Messung von Messwerte (z.B. Spannungswerte, Wirkleistungswerte, Blindleistungswerte, etc.) erfolgt meist durch in einem Niederspannungsnetz installierte Messeinheiten, wobei als Messeinheiten z.B. bei Netzknoten-/-abzweigen und/oder bei Versorgungsanschlüssen für das jeweilige Niederspannungsnetze (z.B. in Transformatorstationen bzw. Ortsnetzstationen) installierte Messsensoren und bei Endverbrauchern angebrachte, so genannte Intelligente Zähler oder Smart Meter verwendet werden können. In einem mehrphasigen, insbesondere einem dreiphasigen Niederspannungsnetz erfolgt die Messung der jeweiligen Messwerte durch die Messeinheiten mehr- bzw. dreiphasig. D.h. es wird von der Messeinheit für jede Phase ein Messwert (z.B. Spannungswert, Wirk- oder Blindleistungswert) gemessen. Zum Erkennen von Störungen in einen Niederspannungsnetz wie z.B. Asymmetrie, Anomalien im Stromnetz, etc. ist daher einen korrekte Zuordnung der Messwerte zu den jeweiligen Phasen unerlässlich.

Zum Sammeln der von den Messeinheiten gemessenen Werte ist bei einem intelligenten Stromnetz bzw. bei einem so genannten Smart-Metering-System eine Datenkonzentrationseinheit vorgesehen. Die Datenkonzentrationseinheit ist üblicherweise beim Versorgungsanschluss des jeweiligen Niederspannungsnetzes, insbesondere bei der Transformatorstation bzw. Ortsnetzstation, angebracht. Von der Datenkonzentrationseinheit werden die im jeweiligen Niederspannungsnetz installierten Messeinheiten überwacht. Weiterhin kommuniziert die Datenkonzentrationseinheit mit einem Zentralsystem beim Energieversorgungsunternehmen, von welchem die Daten der Messeinheiten verarbeitet werden.

Nach Installation einer Messeinheit wie z.B. eines im Netz angebrachten Messsensors oder eines beim Endverbraucher installierten Smart Meters erfolgt üblicherweise eine Konfiguration der von der jeweiligen Messeinheit gemessenen und ausgesendeten Messwerte auf ihre Phasenzugehörigkeit. Diese Zuordnung steht beispielsweise der Datenkonzentrationseinheit oder einer dezentralen Netzregeleinheit in der zum jeweiligen Niederspannungsnetz Ortnetzstation zur Verfügung und ermöglicht es eingehende Messwerte auch phasenspezifisch weiterzuverarbeiten.

Eine Grundvoraussetzung für eine korrekte, phasenspezifische Weiterverarbeitung der Messwerte ist eine korrekte Installation der jeweiligen Messeinheit. Bei Smart Meter kann beispielsweise durch eine Einbau an einem entsprechenden Einbauplatz, häufig sogar mit einem vordefinierten Stecksockel, die Fehleranfälligkeit bei der Phasenzuordnung von Messwerten erheblich reduziert werden. Allerdings muss nach der Installation des Smart Meters bzw. intelligenten Zählers die Phasenzuordnung der Messwerte auf ihre Richtigkeit überprüft werden - d.h. es wird z.B. manuell geprüft, ob eine Phase, welche einem Messwert während der Konfiguration zugeordnet wurde, tatsächlich jener Phase entspricht, an welcher der Messwert vom intelligenten Zähler gemessen wird.

Bei Messsensoren ohne vordefinierten Einbauplatz (z.B. Messsensoren bei Netzknoten/-abzweigen, etc. des Niederspannungsnetzes) ist vor allem auf eine korrekte Installation zu achten. D.h. es muss auf eine korrekte Verdrahtung der Stromwandler und eine richtige Zuordnung der Spannungsabgriffe zu den Phasen geachtet werden. Nur bei einer korrekten Installation können die Messwerte des Messsensors den Phasen richtig zugeordnet werden. Auch hier ist gegebenenfalls einen manuelle Überprüfung der Phasenzuordnung notwendig, um fehlerhafte Zuordnungen zu erkennen und zu korrigieren.

Bei Smart-Meter-Systemen, von welchen für die Übertragung der Messwerte die so genannte Powerline Communication (PLC) eingesetzt wird, kann die Tatsache genutzt werden, dass für die Kommunikation der Messwerte z.B. zur Datenkonzentrationseinheit bzw. zur Ortsnetzstation jenes Medium - d.h. die zu messenden Leitungen - verwendet wird, für welches auch die Messwerte zu bestimmen sind. Beim Einsatz von PLC als Übertragungsmethode kann daher eine richtige Phasenzuordnung der Messwerte sichergestellt werden. Allerdings kann bei PLC beispielsweise aufgrund Störungen wie z.B. stark verrauschte Übertragungsbänder, Interferenzen, etc. eine Phasenzuordnung der Messwerte zum Teil nicht vollkommen eindeutig sein. Werden für die Daten- bzw. Messwerteübertragung andere Kommunikationsmethoden wie z.B. Funkübertragung z.B. mittels GSM, RF Mesh, etc. eingesetzt, dann muss für eine korrekte Phasenzuordnung bzw. für die Überprüfung der Phasenzuordnung der Messwerte eine andere Vorgehensweise gefunden werden. Die Phasenzuordnung kann dann beispielsweise mit relativ großem Aufwand manuell überprüft werden - d.h. es werden Messungen vor Ort (an der jeweiligen Messeinheit) mit den Messergebnissen, welche z.B. an der Datenkonzentrationseinheit vorliegen, auf eine Übereinstimmung der jeweiligen Phase verglichen und bei Fehlern die entsprechende Phasenzugehörigkeit angepasst. Ein derartiges Vorgehen ist allerdings bei einer großen Anzahl an Messeinheiten - insbesondere bei vielen intelligenten Zählern - im Niederspannungsnetz kaum praktikabel.

Aus der Schrift DE 10 2008 044 915 A1 ist beispielsweise ein Verfahren zur automatischen Phasenerkennung mit fernauslesbaren Elektrizitätszählern bekannt. Dabei wird für einen erster Zähler, welche in der Transformatorstation angebracht ist, eine Bezugsphase definiert und mit einer hervorgehobenen lokalen und bekannten Bezugsphase der Transformatorstation verbunden. D.h. in der Transformatorstation bzw. beim zugehörigen Datenkonzentrator ist diese Bezugsphase des ersten Zählers bekannt. Werden weitere Zähler im Netz installiert, so wird mittels Datendiagrammen eine Zeitdifferenz und daraus einen Phasenverschiebung der Bezugsphase des jeweiligen Zählers zur Bezugsphase des ersten Zähler bestimmt und daraus die jeweilige Bezugsphase des jeweiligen Zählers abgeleitet. Damit kann zwar eine Bezugsphase eines Zählers automatisiert bestimmt werden, es ist allerdings kaum möglich, mit dem in der Schrift DE 10 2008 044 915 A1 beschriebenen Verfahren den Messwerten der jeweiligen Zähler die entsprechende Phase automatisch und korrekt zuzuordnen.

Ein ähnliches Verfahren ist aus der Schrift US 8,326,554 B2 bekannt, bei welchem eine Messeinheit von einem Remotesystem mehrere Referenzsignale für den Nulldurchgang der phasenspezifischen Spannungsverläufe erhält. Dabei weisen die Referenzsignale einen exakten Zeitstempel auf, welcher dann von der Messeinheit mit einem Zeitpunkt bzw. Zeitstempel des Nulldurchgangs des phasenspezifischen Spannungsverlaufs der Messeinheit verglichen wird. Aus diesem Vergleich wird dann anhand einer Zeitdifferenz eine Phase bestimmt, mit welcher die Messeinheit verbunden ist. Allerdings ist auch hier eine korrekte und laufende Zuordnung von Messwerten zu einer Phase nur schwer bis kaum möglich. Die Druckschrift US 2014/077970 A1 offenbart eine Klassifizierung von Messeinheiten nach Phasenzugehörigkeit. Dabei wird ein phasenspezifisches Referenzsignal verwendet, dessen Synchronisierung mit einem Messsignal der Messeinheiten verglichen wird. Das Referenzsignal kann ein Nulldurchgang sein. Die Messeinheiten werden in Abhängigkeit der Synchronisierung klassifiziert, also einer Phase zugeordnet.

### Darstellung der Erfindung

Der Erfindung liegt daher die Aufgabe zugrunde, ein Verfahren zur automatischen Phasenerkennung von Messwerten, welche von in einem mehrphasigen Niederspannungsnetz installierten Messeinheiten gemessen werden, anzugeben, durch welches auf einfache Weise, ohne manuellen Eingriff und ohne komplexe Mess- und Rechenvorgänge und mit hoher Zuverlässigkeit den von Messeinheiten gemessenen Messwerten eine korrekte Phase zugewiesen und eine Phasenzuordnung der Messwerte im laufenden Betrieb geprüft werden kann.

Diese Aufgabe wird durch ein Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren der eingangs erwähnten Art, bei welchem für einen vorgebbaren Betrachtungszeitraum die Messwerte der Messeinheiten z.B. von der Datenkonzentrationseinheit und/oder von einer übergeordneten Zentralsystem bei jeweiligen Energieversorger gesammelt werden. Der vorgebbare Betrachtungszeitraum wird dann in mehrere zeitliche Abschnitte unterteilt, welchen die Messwerte der Messeinheiten anhand ihrer Zeitstempel zugeordnet werden. Anhand von Referenzwerten für jeden der zeitlichen Abschnitte wird dann ein unabhängiger Klassifikator erzeugt. Mittels des jeweiligen unabhängigen Klassifikators werden den Messwerten des jeweiligen zeitlichen Abschnitts die entsprechenden Phasen zugewiesen.

Der Hauptaspekt der gegenständlichen Erfindung besteht darin, dass mittels des erfindungsgemäßen Verfahrens Messwerte der im Niederspannungsnetz installierten Messeinheiten (z.B. intelligente Zähler, Messsensoren) über einen längeren Betrachtungszeitraum (z.B. einen oder zwei Tage) gesammelt werden, wobei die Messwerte in regelmäßigen Intervallen - im Idealfall zeitlich synchronisiert und getaktet - bei der Datenkonzentrationseinheit eingehen bzw. über die Datenkonzentrationseinheit an ein Zentralsystem weitergeleitet werden. Dann wird auf Basis einer iterativen Klassifizierung anhand von Referenzwerten die jeweilige Phasenzugehörigkeit der jeweils im vorgegebenen Betrachtungszeitraum eingegangenen Messwerte bestimmt.

Damit wird auf einfache Weise, ohne manuellen Eingriff und/oder komplexe Mess- und/oder Rechenverfahren ein automatisiertes Erkennen der Phasenzugehörigkeit der von den Messeinheiten gelieferten Messwerte ermöglicht. Diese automatisierte Phasenerkennung erfolgt mit sehr hoher Zuverlässigkeit und liefert einen wichtige Basis für nachgelagerte Analysen, bei welchen beispielsweise Aussagen über eine tatsächliche Auslastung, Spannungsbandverhältnisse und/oder über möglich Asymmetrien im Netz getroffen werden können. Weiterhin kann vom erfindungsgemäßen Verfahren einen wichtige Voraussetzung geliefert werden, um operative Kosten in einem Versorgungsnetz bei Einführung von intelligenten Systems (z.B. Smart Grids, Smart-Metering-Systemen, etc.) möglichst gering zu halten. Damit können beispielsweise aktive Netzmanagementsysteme durch die vom erfindungsgemäßen Verfahren gelieferten Messwerte mit korrekter Phasenzuordnung effizienter und höherer Präzision arbeiten. Weiterhin können -durch die Möglichkeit mit dem erfindungsgemäßen Verfahren eine Phasenzuordnung der Messwerte im laufenden Betrieb zu prüfen - insbesondere planungstechnische Maßnahmen wie z.B. Korrekturen von Phasendrehungen bei der Verkabelung der Messeinheiten in Kabelverteilschränken, etc. ergriffen werden.

Eine bevorzugte Weiterbildung des erfindungsgemäßen Verfahrens sieht vor, dass bei zeitlich unsynchronisiert vorliegenden Messwerten zuerst im vorgebbaren Betrachtungszeitraum eine zeitliche Synchronisation der Messwerte für die jeweiligen Messeinheiten durchgeführt wird. Bei zeitlich unsynchronisiert vorliegende Messwerte weisen die Messwerte der jeweiligen Messeinheiten unterschiedliche Zeitstempel auf. Weiterhin kann die Anzahl der je Messeinheit vorliegenden Messwerte im Betrachtungszeitraum variieren - d.h. eine Dimension der so genannten Zeitstempelvektoren der einzelnen Messeinheiten kann sich in einem Niederspannungsnetz beispielsweise zwischen 85 und 261 bewegen. Mittels der Synchronisation werden die im Betrachtungszeitraum von den Messeinheiten gelieferten Messwerte derart aufbereitet, dass für jede Messeinheit dieselbe Anzahl an Zeitstempel, welche auf definierte Zeitpunkte (z.B. auf Minuten) für den vorgebbaren Betrachtungszeitraum zeitlich abgeglichen sind. Nach der Synchronisation weisen die Zeitstempelvektoren der jeweiligen Messeinheiten dieselbe Dimension und zeitlich synchronisierte Zeitstempel auf.

Es ist vorteilhaft, wenn für jeden Messwert die für die unterschiedlichen zeitlichen Abschnitte ermittelten bzw. zugewiesenen Phasen kombiniert werden, und wenn dann eine Häufigkeit einer Zuordnung der jeweiligen Phase zum jeweiligen Messwert ausgewertet wird. Da für jeden zeitlichen Abschnitt ein eigenständiger Klassifikator ermittelt wurde, sind die Ergebnisse der Phasenzuordnung für die Messwerte einer Messeinheit für den jeweiligen Abschnitt voneinander unabhängig. Um die Qualität der Phasenzuordnung für einen phasenspezifischen Messwert einer Messeinheit zu erhöhen, wird die Häufigkeit der Zuordnung der jeweiligen Phasen anhand einer vorgebbaren Entscheidungsregel für jeden Messwert untersucht und dann eine Aussage über ein Zutreffen der Zuordnung getroffen. Die Genauigkeit der Phasenzuordnung zu den jeweiligen Messwerten kann durch eine Vergrößerung des Betrachtungszeitraums (z.B. zwei Tage anstatt eines Tags) sowie durch eine größere Anzahl an zeitlichen Abschnitten (z.B. 6 Abschnitte anstatt 3 Anschnitten) weiter erhöht werden.

Idealerweise werden die Referenzmesswerte von Referenzmesseinheiten erstellt, wobei die Phasenzugehörigkeit der einzelnen Referenzmesswerte bekannt ist. Diese Referenzmesseinheiten sind vorteilhafter Weise in unterschiedlichen Strängen des Niederspannungsnetzes installiert. Zumindest eine der Referenzmesseinheiten kann dabei in der Ortsstation bzw. bei der Datenkonzentrationseinheit angebracht sein, da dort am einfachsten die Phasenzugehörigkeit der Messwerte der Referenzmesseinheit sehr leicht und rasch ermittelt werden können.

Die Klassifizierung der Phasen - d.h. einen Zuordnung der jeweiligen Messwerte zu einer der im Niederspannungsnetz vorkommenden Phasen - kann beispielsweise mittels eines geeigneten so genannten Machine Learning Algorithmus durchgeführt werden. Bei der vorliegenden Erfindung werden idealerweise Klassifikatoren für die jeweiligen zeitlichen Abschnitte so genannte Support Vector Machines eingesetzt, welche für die Klassifizierung von Zeitreihen (wie für die im Betrachtungszeitraum gesammelten, zeitliche Abfolgen der Messwerte der Messeinheiten) gut geeignet sind. Eine Support Vector Machine unterteilt eine Menge von Werten oder Objekten so in Klassen, dass um die Klassengrenzen herum ein möglichst breiter Bereich frei von Werten bzw. Objekten bleibt, welcher für einen möglichst zuverlässige Klassifizierung der Werte bzw. Objekte sorgen soll. Eine Ausgangsbasis für ein Erstellen einer Support Vector Machine wird von einer Menge an Trainingswerten bzw. -objekten (z.B. Referenzwerten) gebildet, welche in Vektorform vorliegen. Mit Hilfe der Referenzwerte als Trainingswerte bzw. -objekte wird dann für jeden Abschnitt ein so genannter Support Vector Machine- oder SVM-Kernel als unabhängiger Klassifikator gebildet.

Idealerweise werden als Messwerte von im Niederspannungsnetz installierten Messeinheiten phasenspezifische Spannungsmesswerte, Wirkleistungs- und/oder Blindleistungsmesswerte erfasst. Anhand der phasenspezifischen Auswertung und Analyse dieser Werte können phasenspezifische Störungen, Asymmetrie oder Anomalien im Niederspannungsnetz auf einfache und rasche Weise erkannt werden und gegebenfalls rasch entsprechende Maßnahmen z.B. Netzmanagement ergriffen werden.

Eine vorteilhafte Fortbildung des erfindungsgemäßen Verfahrens sieht vor, dass für das erfindungsgemäße Verfahren eine laufende oder sich periodisch wiederholende Durchführung vorgesehen ist. D.h. das erfindungsgemäße Verfahren kann beispielsweise zu definierten Zeitpunkten periodisch wiederholt werden - es wird dann z.B. immer zu einem definierten Zeitpunkt (z.B. Mitternacht, etc.) mit dem Sammeln der phasenspezifischen Messwerte der Messeinheiten begonnen und nach Ablauf des vorgebbaren Betrachtungszeitraums (z.B. ein Tag) die Phasenzuordnung und Auswertung der Messwerte angestoßen. Alternativ, kann ein Sammeln der Messwerte auch laufend durchgeführt werden und für die Phasenzuordnung und Auswertung ein vorgebbarer Beobachtungszeitraum anhand der Zeitstempel der Messwerte aus den gesammelten Messwerten herausgegriffen werden.

### Kurzbeschreibung der Zeichnung

Die Erfindung wird nachfolgend in beispielhafter Weise anhand der beigefügten Figuren erläutert. Dabei zeigen:
- Figur 1: schematisch eine Aufbau eines beispielhaften Niederspannungsnetzes, in welchem das erfindungsgemäße Verfahren zur automatischen Phasenerkennung von Messwerten eingesetzt werden kann
- Figur 2: schematisch einen beispielhaften Ablauf des erfindungsgemäßen Verfahrens zur automatischen Phasenerkennung von phasenspezifischen Messwerten in einem Niederspannungsnetz

### Ausführung der Erfindung

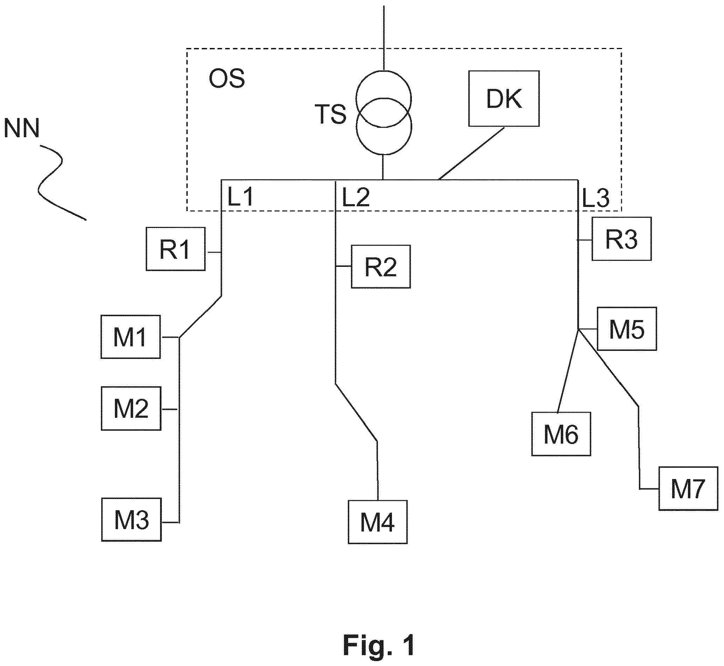

Figur 1 zeigt in schematischer Weise ein beispielhaftes Niederspannungsnetz NN. Dieses Niederspannungsnetz NN umfasst eine beispielhafte Ortsnetzstation OS, in welcher ein Transformator bzw. eine Transformatorstation TS untergebracht ist, durch welche z.B. Energie bzw. elektrischer Strom aus einem Mittelspannungsnetz auf eine Spannungsniveau des Niederspannungsnetzes NN transformiert wird. Weiterhin ist in der Ortsnetzstation OS eine Datenkonzentrationseinheit DK angebracht. Von der Datenkonzentrationseinheit DK wird üblicherweise mit einem übergeordneten Zentralsystem beim jeweiligen Energieversorgungssystem über ein Kommunikationsnetz kommuniziert. Weiterhin werden von der Datenkonzentrationseinheit DK die im beispielhaften Niederspannungsnetz NN installierten Messeinheiten R1, R2, R3, M1 bis M7 (z.B. intelligente Zähler, Messsensoren, etc.) überwacht und die von den im Niederspannungsnetz NN installierten Messeinheiten R1, R2, R3, M1, ..., M7 gemessenen Messwerte gesammelt. Die gesammelten Messwerte können von der Datenkonzentrationseinheit DK beispielsweise für Auswertung und/oder Abrechnungsvorgänge an das übergeordnete Zentralsystem weitergeleitet werden.

Das in Figur 1 beispielhaft dargestellte Niederspannungsnetz NN weist weiterhin z.B. drei Leitungsstränge L1, L2, L3 auf.

Diese Leitungsstränge L1, L2, L3 sind mehrphasig - beispielsweise dreiphasig - ausgeführt. D.h. jeder Leitungsstrang L1, L2, L3 weist z.B. drei Außenleiter auf, welcher wegen der besseren Übersichtlichkeit in Figur 1 nicht dargestellt sind. Den Außenleitern wird ein sinusförmiger Spannungsverlauf für eine Übertragung der elektrischen Energie aufgeprägt und damit die jeweiligen, angeschlossenen Verbraucher-Einheiten mit Energie versorgt. Andererseits können an die dreiphasigen Leitungsstränge L1, L2, L3 auch Erzeuger-Einheiten wie z.B. eine Photovoltaik-Anlage oder eine kleine Windkraftanlage angeschlossen sein, von welchen dezentral Energie in das Niederspannungsnetz NN eingespeist wird.

Weiterhin sind in den Leitungssträngen L1, L2, L3 des Niederspannungsnetzes NN Messeinheiten R1, R2, R3, M1, ..., M7 angebracht. Von diesen Messeinheiten werden im Netz NN bzw. bei Verbraucheranschlüssen Messwerte wie z.B. Spannungswerte, Wirkleistungs- und/oder Blindleistungswerte je Phase gemessen. Dadurch können einerseits Störungen im Niederspannungsnetz NN erkannt und andererseits ein Verbrauch und/oder ein Einspeisung von Energie an den Verbraucheranschlüssen gemessen werden. D.h. von jeder Messeinheit R1, R2, R3, M1, ..., M7 wird für jede Phase ein Wert (z.B. Spannung, Wirkleistung, Blindleistung) gemessen und mit einem Zeitstempel versehen regelmäßig an die Datenkonzentrationseinheit DK übermittelt.

Zum phasenspezifischen Messen von z.B. Spannung, Wirkleistung und/oder Blindleistung sind beim beispielhaften Niederspannungsnetz NN in einem ersten Leitungsstrang L1 die Messeinheiten R1, M1, M2 und M3, in einem zweiten Leitungsstrang die Messeinheiten R2 und M4 und in einem dritten Leitungsstrang die Messeinheiten R3, M5, M6 und M7 vorgesehen. Als Messeinheiten R1, R2, R3, M1, ..., M7 können beispielsweise im Niederspannungsnetz installierte Messsensoren oder bei Verbrauchern und/oder Erzeugern angebrachte intelligente Zähler verwendet werden, von welchen die Messwerte phasenspezifisch gemessen werden.

Für eine Durchführung des erfindungsgemäßen Verfahrens zur automatischen Phasenerkennung von Messwerten werden Referenzmesswerte eingesetzt, welche von Referenzmesseinheiten R1, R2, R3 gemessen werden. Die Referenzmesseinheiten R1, R2, R3 sind idealerweise in unterschiedlichen Leitungssträngen L1, L2, L3 des Niederspannungsnetzes NN installiert. So ist im beispielhaften Niederspannungsnetz NN eine erste Referenzmesseinheit R1 im ersten Leitungsstrang L1, eine zweite Referenzmesseinheit R2 im zweiten Leitungsstrang L2 und eine dritte Referenzmesseinheit R3 im dritten Leitungsstrang L3 angebracht. Weiterhin ist bei den Referenzmesswerten der Referenzmesseinheiten R1, R2, R3 die jeweilige Phasenzugehörigkeit der jeweils gemessenen Werte bekannt. Als Referenzmesseinheiten R1, R2, R3 können beispielsweise Messsensoren gewählt werden, welche z.B. in der Ortsnetzstation OS oder in deren Nähe angebracht sind.

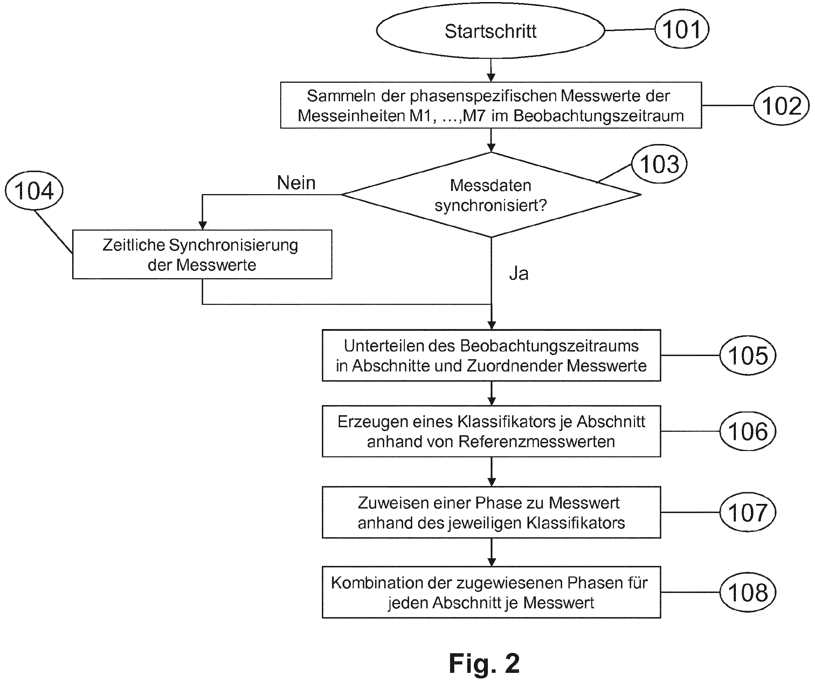

Figur 2 zeigt nun einen beispielhaften Ablauf des erfindungsgemäßen Verfahrens zur automatischen Phasenerkennung von Messwerten, welche den im Niederspannungsnetz NN installierten Messeinheiten M1, ..., M7 je Phase gemessen worden sind. Das erfindungsgemäße Verfahren wird dabei beispielhaft anhand von gemessenen, phasenspezifischen Spannungswerten erläutert. Es kann aber auch für phasenspezifisch gemessene Wirkleistungs- und/oder Blindleistungswerte angewendet werden.

Das erfindungsgemäße Verfahren beginnt mit einem Startschritt 101. In einem zweiten Verfahrensschritt 102 werden für einen vorgebbaren Beobachtungszeitraum von den Messeinheiten M1, ..., M7 phasenweise gemessene Messwerte wie z.B. Spannungswerte gesammelt. Als Beobachtungszeitraum wird ein längerer Zeitraum wie z.B. ein Tag, zwei oder mehrere Tage gewählt. Die Messwerte können beispielsweise von der Datenkonzentrationseinheit DK gesammelt werden, an welche die Messwerte von den Messeinheiten M1, ..., M7 in regelmäßigen Intervallen übertragen werden und auf welcher die Messwerte mit einem Zeitstempel versehen vorliegen.

In einem dritten Verfahrensschritt 103 wird geprüft, ob die Messwerte bzw. Spannungswerte auf der Datenkonzentrationseinheit DK bereits synchronisiert oder unsynchronisiert vorliegen. Bei unsynchronisiert vorliegenden Messwerten wird in einem vierten Verfahrensschritt 104 eine zeitliche Synchronisierung der vorliegenden Messwerte durchgeführt.

Dabei wird zuerst der Beobachtungszeitraum (z.B. ein Tag), für welchen die Messwerte gesammelt wurden, in Intervalle wie z.B. Minutenintervalle unterteilt. Alle Messwerte einer Messeinheit M1, ..., M7, welche in einem Intervall gemessen und geliefert wurden, werden dann gemittelt. Wenn für ein Intervall von einer Messeinheit M1, ..., M7 keine Messwerte vorliegt, so wird für diesen Wert ein Platzhalter wie z.B. NaN eingefügt. Dies wird für alle Phasen getrennt und je Messeinheit M1, ..., M7 durchgeführt und ist beispielhaft in der Tabelle 1 dargestellt. In der Tabelle 1 sind beispielhaft Minutenintervalle für eine erste Messeinheit M1 mit den je Phase gemessenen und gemittelten Spannungswerten für das jeweilige Intervall angeführt. Nicht existente Messwerte sind durch den Platzhalter NaN ersetzt - d.h. für dieses Intervall wurden von der beispielhaften Messeinheit M1 für die jeweilige Phase keine Messwerte gemessen und/oder übertragen.

**Tabelle 1**

| Messeinheit | Zeitpunkt | Phase 1 | Phase 2 | Phase 3 |
|---|---|---|---|---|
| M1 | 06.05.2016 - 00:00 | 236,5 | 236,3 | 236,1 |
| M1 | 06.05.2016 - 00:01 | 237,0 | 236,4 | NaN |
| M1 | 06.05.2016 - 00:02 | 236,9 | NaN | 236,0 |
| M1 | 06.05.2016 - 00:03 | 236,8 | NaN | 235,85 |
| M1 | 06.05.2016 - 00:04 | 236,65 | 236,1 | 235,6 |
| M1 | 06.05.2016 - 00:05 | 236,4 | 235,8 | 235,35 |
| M1 | 06.05.2016 - 00:06 | 236,25 | 235,6 | 235,1 |
| M1 | 06.05.2016 - 00:07 | 236,1 | NaN | NaN |
| M1 | 06.05.2016 - 00:08 | 236,0 | NaN | NaN |
| M1 | 06.05.2016 - 00:09 | NaN | NaN | NaN |
| M1 | 06.05.2016 - 00:10 | NaN | NaN | NaN |
| M1 | 06.05.2016 - 00:11 | NaN | NaN | NaN |
| M1 | 06.05.2016 - 00:12 | NaN | 235,9 | NaN |

Für eine bessere Verwendbarkeit werden die mit dem Platzhalter NaN als undefiniert gekennzeichneten Werte aus dem Datensatz der jeweiligen Messeinheit M1, ..., M7 wieder entfernt oder geeignet ersetzt. Dabei werden zuerst - wie in Tabelle 2 dargestellt - alle jene Zeitpunkte bzw. Intervalle entfernt, für welche in allen drei Phasen der Platzhalter NaN eingesetzt wurde. Diese Zeitpunkte bzw. Intervalle sind für die weiteren Betrachtungen nicht relevant.

**Tabelle 2**

| Messeinheit | Zeitpunkt | Phase 1 | Phase 2 | Phase 3 |
|---|---|---|---|---|
| M1 | 06.05.2016 - 00:00 | 236,5 | 236,3 | 236,1 |
| M1 | 06.05.2016 - 00:01 | 237,0 | 236,4 | NaN |
| M1 | 06.05.2016 - 00:02 | 236,9 | NaN | 236,0 |
| M1 | 06.05.2016 - 00:03 | 236,8 | NaN | 235,85 |
| M1 | 06.05.2016 - 00:04 | 236,65 | 236,1 | 235,6 |
| M1 | 06.05.2016 - 00:05 | 236,4 | 235,8 | 235,35 |
| M1 | 06.05.2016 - 00:06 | 236,25 | 235,6 | 235,1 |
| M1 | 06.05.2016 - 00:07 | 236,1 | NaN | NaN |
| M1 | 06.05.2016 - 00:08 | 236,0 | NaN | NaN |
| M1 | 06.05.2016 - 00:12 | NaN | 235,9 | NaN |

Die restlichen, mittels des Platzhalters NaN als undefiniert gekennzeichneten Werte werden dann mit geeigneten Werten ergänzt. Dazu wird anstelle des Platzhalters NaN ein letzter bekannter Messwert der jeweiligen Messeinheit M1 für die jeweilige Phase in das jeweilige Intervall eingetragen. Die Ergänzung der entsprechenden Messwerte ist in der Tabelle 3 dargestellt, wobei ergänzte Messwerte fett geschrieben und unterstrichen sind.

**Tabelle 3**

| Messeinheit | Zeitpunkt | Phase 1 | Phase 2 | Phase 3 |
|---|---|---|---|---|
| M1 | 06.05.2016 - 00:00 | 236,5 | 236,3 | 236,1 |
| M1 | 06.05.2016 - 00:01 | 237,0 | 236,4 | **236,1** |
| M1 | 06.05.2016 - 00:02 | 236,9 | **236,4** | 236,0 |
| M1 | 06.05.2016 - 00:03 | 236,8 | **236,4** | 235,85 |
| M1 | 06.05.2016 - 00:04 | 236,65 | 236,1 | 235,6 |
| M1 | 06.05.2016 - 00:05 | 236,4 | 235,8 | 235,35 |
| M1 | 06.05.2016 - 00:06 | 236,25 | 235,6 | 235,1 |
| M1 | 06.05.2016 - 00:07 | 236,1 | **235,6** | **235,1** |
| M1 | 06.05.2016 - 00:08 | 236,0 | **235,6** | **235,1** |
| M1 | 06.05.2016 - 00:12 | **236,0** | 235,9 | **235,1** |

Als Resultat liegen damit für alle Messeinheiten M1, ..., M7 phasenspezifische Messwerte mit Zeitstempeln entsprechend der vorgegebenen Intervalle - beispielsweise zu vollen Minuten vor. Allerdings kann ein abgedecktes Zeitintervall bzw. eine Anzahl an Zeitpunkten, für welche für jede Phase Messwerte vorliegen, für den jeweils vorgebbare Betrachtungszeitraum (z.B. ein Tag) für jede Messeinheit M1, ..., M7 unterschiedlich sein. In einem Niederspannungsnetz NN kann sich eine Anzahl der Zeitstempel je Messeinheit M1, ..., M7 beispielsweise zwischen 85 und 261 bewegen. Durch die Anzahl an Zeitstempel wird auch eine Länge des so genannten Zeitstempelvektors der jeweiligen Messeinheit M1, ..., M7 festgelegt.

Für weitere Verfahrensschritte 105, ..., 108 bzw. für einen korrekte Phasenzuweisung zu den Messwerten wird allerdings eine einheitliche Dimension der Zeitstempelvektoren bzw. der Messdatensätze der unterschiedlichen Messeinheiten M1, ..., M7 benötigt. Da Werte von unterschiedlichen Messeinheiten M1, ..., M7 nach der oben ausgeführten Aufbereitung der Messwerte in unterschiedlicher Dimensionalität vorliegen können, wird zuerst jene Messeinheit M1, ..., M7 mit den meisten Datenpunkten bzw. Zeitstempeln gesucht und dann die Zeitstempel dieser Messeinheit M1, ..., M7 auf die anderen Messeinheiten M1, ..., M7 übertragen. Damit weisen alle Messeinheiten M1, ..., M7 einen Index bzw. die Zeitstempel jener Messeinheit M1, ..., M7 mit den meisten Datenpunkten auf. Im Allgemeinen stimmen aber die neuen Zeitstempel nicht mit den alten Zeitstempeln überein bzw. es liegen für die neuen, übernommenen Zeitstempel keine Messwerte vor. Daher werden als neue Messwerte für die übernommen Zeitstempel die jeweils letztgültige Messwerte der jeweiligen Messeinheit M1, ..., M7 gewählt.
In der folgenden Tabelle 4 wird dieser Vorgang beispielhaft anhand der beispielshaft ausgewählten Messeinheiten M1 und M7 dargestellt. Die erste Messeinheit M1 ist die Messeinheit M1 mit den meisten Datenpunkten bzw. Zeitstempeln. Die Zeitstempel der ersten Messeinheit M1 werden von der zweiten Messeinheit M7 - und damit von jeder weiteren Messeinheit M2, ..., M6 des Niederspannungsnetzes NN übernommen. Die Messwerte der zweiten Messeinheit M6 werden - wie in Tabelle 4 dargestellt - an die neuen Zeitstempel angepasst.

**Tabelle 4**

| Messeinheit | Zeitpunkt | Phase1 | Phase2 | Phase3 | | Messeinheit | Zeitpunkt | Phase1 | Phase2 | Phase3 |
|---|---|---|---|---|---|---|---|---|---|---|
| M1 | ... | ... | ... | ... | 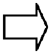 | M1 | ... | ... | ... | ... |
| M1 | 00:46 | 238,0 | 237,5 | 236,7 | | M1 | 00:46 | 238,0 | 237,5 | 236,7 |
| M1 | 00:54 | 238,1 | 236,7 | 236,7 | | M1 | 00:54 | 238,1 | 236,7 | 236,7 |
| M1 | 01:11 | 238,1 | 237,7 | 236,7 | | M1 | 01:11 | 238,1 | 237,7 | 236,7 |
| M1 | 01:17 | 238,1 | 237,9 | 236,8 | | M1 | 01:17 | 238,1 | 237,9 | 236,8 |
| M1 | 01:24 | 238,2 | 237,9 | 237,0 | | M1 | 01:24 | 238,2 | 237,9 | 237,0 |
| M1 | ... | ... | ... | ... | | M1 | ... | ... | ... | ... |
| | | | | | | | | | | |
| M7 | ... | ... | ... | ... | 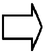 | M7 | ... | ... | ... | ... |
| M7 | 00:52 | 238,1 | 237,5 | 236,7 | | M7 | 00:46 | 238,1 | 237,5 | 236,7 |
| M7 | 01:09 | 238,1 | 237,6 | 236,7 | | M7 | 00:54 | 238,1 | 237,5 | 236,7 |
| M7 | 01:17 | 238,1 | 237,8 | 236,7 | | M7 | 01:11 | 238,1 | 237,6 | 236,7 |
| M7 | 01:18 | 238,2 | 237,9 | 236,9 | | M7 | 01:17 | 238,1 | 237,8 | 236,7 |
| M7 | 01:26 | 238,2 | 237,9 | 237,1 | | M7 | 01:24 | 238,2 | 237,9 | 236,9 |
| M7 | ... | ... | ... | ... | | M7 | ... | ... | ... | ... |

Nach der oben beschriebenen Aufbereitung der unsynchronisiert vorliegenden Messwerte im vierten Verfahrensschritt 104 weist nun jeder Messwert-Datensatz bzw. Zeitstempelvektor der Messeinheiten M1, ..., M7 gleich viele Datenpunkte bzw. Zeitstempel auf, welche auf die jeweils vorgegebenen Intervalle (z.B. auf volle Minuten) über den Beobachtungszeitraum (z.B. einen Tag) synchronisiert sind.
Bei synchronisiert vorliegenden Messwerten, welche synchron und getaktet auf der Datenkonzentrationseinheit DK eingehen, kann der vierte Verfahrensschritt 104 entfallen. Bei diesen Messwerten sind die Zeitstempel synchron und die Datensätze bzw. Zeitstempelvektoren der Messeinheiten M1, ..., M7 weisen dieselbe Dimensionalität auf.

In einem fünften Verfahrensschritt 105 wird der Beobachtungszeitraum (z.B. ein Tag) in mehrere zeitliche - beispielsweise drei - Abschnitte unterteilt. Dann werden die entweder synchronisiert vorliegende oder im vierten Verfahrensschritt 104 synchronisierten Messwerte anhand ihrer Zeitstempel den jeweiligen zeitlichen Abschnitten zugeordnet.

In einem sechsten Verfahrensschritt 106 wird anhand von Referenzmesswerten für jeden der zeitlichen Abschnitte ein unabhängiger Klassifikator generiert. Die Referenzmesswerte werden von den Referenzmesseinheiten R1, R2, R3 zur Verfügung gestellt, wobei die jeweilige Phasenzugehörigkeit der einzelnen Referenzmesswerte bekannt ist. Als unabhängige Klassifikatoren für die jeweiligen zeitlichen Abschnitte werden beispielsweise so genannte Support Vector Machines bzw. SVM-Kernels eingesetzt, welche insbesondere gut für eine Klassifizierung von Zeitreihen geeignet sind. Auf Basis der unabhängigen Klassifikatoren können dann die einzelnen Messwerte der Messeinheiten M1, ..., M7 in den einzelnen Abschnitten in einem siebenten Verfahrensschritt 107 den jeweiligen Phasen zugewiesen werden. D.h. jedem Messwerte jeder Messeinheit M1, ..., M7 in jedem zeitlichen Abschnitt wird mittels des zum jeweiligen Abschnitt gehörenden Klassifikators ein Phase zugeordnet. Eine beispielshafte Klassifizierung der Messwerte, wie sie nach dem siebenten Verfahrensschritt 107 vorliegt, ist beispielhaft in Tabelle 5 dargestellt, wobei der Betrachtungszeitraum z.B. von einem Tag in drei, äquivalente zeitliche Abschnitte unterteilt wurde.

**Tabelle 5**

| **Abschnitt 1 (0:00 - 8:00)** | |
|---|---|
| **Messeinheit** - **Messwert** | **Zugewiesene Phase** |
| M1 - Messwert 1 | 1 |
| M1 - Messwert 2 | 3 |
| M1 - Messwert 3 | 3 |
| ... | |
| M7 - Messwert 1 | 3 |
| M7 - Messwert 2 | 2 |
| M7 - Messwert 3 | 1 |
| | |

| **Abschnitt 2 (8:00 - 16:00)** | |
|---|---|
| **Messeinheit - Messwert** | **Zugewiesene Phase** |
| M1 - Messwert 1 | 2 |
| M1 - Messwert 2 | 2 |
| M1 - Messwert 3 | 3 |
| ... | |
| M7 - Messwert 1 | 3 |
| M7 - Messwert 2 | 3 |
| M7 - Messwert 3 | 3 |
| | |

| **Abschnitt 3 (16:00 - 24:00)** | |
|---|---|
| **Messeinheit** - **Messwert** | **Zugewiesene Phase** |
| M1 - Messwert 1 | 1 |
| M1 - Messwert 2 | 2 |
| M1 - Messwert 3 | 3 |
| ... | |
| M7 - Messwert 1 | 2 |
| M7 - Messwert 2 | 2 |
| M7 - Messwert 3 | 1 |

Wie aus der in Tabelle 5 beispielhaft dargestellten Klassifizierung ersichtlich, können die Klassifizierungen der einzelnen zeitlichen Abschnitte nicht immer konsistent sein - d.h. es werden einem Messwert - z.B. einem ersten Messwert 1 der ersten Messeinheit M1 - in den unterschiedlichen, zeitlichen Abschnitten unterschiedliche Phasen zugewiesen oder mehreren Messwerten einer Messeinheit M1, ..., M7 wird in einem Abschnitt dieselbe Phase zugeordnet - wie z.B. den Messwerten der Messeinheit M7 im Abschnitt 2.

Um die Qualität und eine Genauigkeit der Phasenzuordnung im siebenten Verfahrensschritt 107 zu erhöhen, kann ein achter Verfahrensschritt 108 vorgesehen sein, bei welchen die Ergebnisse mehrere Klassifizierungen kombiniert werden. Die Klassifikationen für die Abschnitte sind voneinander unabhängig, da für jeden zeitlichen Abschnitt ein eigenständiger Klassifikator erstellt wurde. Im achten Verfahrensschritt werden für jeden Messwert die für die unterschiedlichen Abschnitte zugewiesenen Phasen kombiniert und dann einen Häufigkeit ausgewertet, mit welcher die jeweilige Phase dem jeweiligen Messwert zugeordnet wurde. Durch die Auswertung der Häufigkeit kann besser entschieden werden, welcher Phase ein Messwert einer Messeinheit M1, ..., M7 eher entspricht.

Es können dabei z.B. für jeden Messwert zwei Fälle unterschieden werden:
- Ein Messwert wird mehr als n/2 mal derselben Phase zugewiesen, wobei n die Anzahl der zeitlichen Abschnitte ist.
- Ein Messwert wird nicht mehr als n/2 mal derselben Phase zugewiesen, wobei n die Anzahl der zeitlichen Abschnitte ist.
Im ersten Fall kann von einer korrekten Zuordnung des Messwerts zur jeweiligen Phase ausgegangen werden. Im zweiten Fall ist die Zuordnung nicht bestimmt - d.h. es kann keinen Aussage bezüglich der Phasenzugehörigkeit des Messwerts getroffen werden. In der folgenden Tabelle 6 ist der achte Verfahrensschritt 108 dargestellt, wobei in Tabelle 6 die in Tabelle 5 dargestellt Phasenzuordnung zu den Messwerten kombiniert und entsprechend der jeweiligen Häufigkeit ausgewertet wird. Die Genauigkeit des erfindungsgemäßen Verfahrens kann durch eine Vergrößerung des Betrachtungszeitraums (z.B. zwei Tage anstatt eines Tags) und eine Vergrößerung der Anzahl der zeitlichen Abschnitte weiter verbessert werden.

**Tabelle 6**

| **Messeinheit - Messwert** | **[Abschnitt1; Abschnitt 2; Abschnitt 3] → Ergebnis** |
|---|---|
| M1 - Messwert 1 | [1; 2; 1] → 1 |
| M1 - Messwert 2 | [3; 2; 2] → 2 |
| M1 - Messwert 3 | [3; 3: 3] → 3 |
| ... | |
| M7 - Messwert 1 | [3; 3; 2] → 3 |
| M7 - Messwert 2 | [2; 3; 2] → 2 |
| M7 - Messwert 3 | [1; 3; 1] → 1 |

Der in Figur 2 beispielhaft dargestellte Ablauf des erfindungsgemäßen Verfahrens kann kontinuierlich oder in periodischen Wiederholungen durchlaufen werden. Bei einer kontinuierlichen Durchführung kann beispielsweise nach Ablauf eines vorgebbaren Betrachtungszeitraums, in welchem die Messwerte für die automatische Phasenzuordnung gesammelt werden, bereits mit einem Sammeln der Messwerte für eine nächste Auswertung begonnen werden. Bei einem Betrachtungszeitraum von einem Tag kann damit das erfindungsgemäße Verfahren z.B. tageweise durchgeführt werden. Bei einer periodisch sich wiederholenden Durchführung kann z.B. ein Wiederholungsintervall für die automatische Phasenerkennung der Messwerte vorgegeben werden - wie z.B. einmal in einem Monat, etc.

## Patentansprüche

1. Verfahren zur automatischen Phasenerkennung von Messwerten, welche von in einem mehrphasigen Niederspannungsnetz (NN) installierten Messeinheiten (M1-M7) phasenspezifisch gemessen, mit einem Zeitstempel versehen und zumindest an eine Datenkonzentrationseinheit (DK) regelmäßig weitergeleitet werden, ***dadurch gekennzeichnet, dass*** für einen vorgebbaren Betrachtungszeitraum die Messwerte der Messeinheiten (M1-M7) gesammelt werden (102), dass der vorgebbare Betrachtungszeitraum in mehrere zeitliche Abschnitte unterteilt wird, welchen die jeweiligen Messwerte anhand ihres Zeitstempels zugeordnet werden (105), dass anhand von Referenzmesswerten für jeden der zeitlichen Abschnitte ein unabhängiger Klassifikator erzeugt wird (106), und dass anhand des jeweiligen unabhängigen Klassifikators den Messwerten des jeweiligen Abschnitts die entsprechenden Phasen zugewiesen werden (107).

2. Verfahren nach Anspruch 1, ***dadurch gekennzeichnet, dass*** bei zeitlich unsynchronisiert vorliegenden Messwerten zuerst eine zeitliche Synchronisation der Messwerte für die jeweiligen Messeinheiten (M1-M7) durchgeführt wird (103, 104) .

3. Verfahren nach einem der Ansprüche 1 bis 2, ***dadurch gekennzeichnet, dass*** für jeden Messwert die für die unterschiedlichen Abschnitte zugewiesenen Phasen kombiniert werden, und dass dann eine Häufigkeit der Zuordnung der jeweiligen Phasen zum jeweiligen Messwert ausgewertet wird (108).

4. Verfahren nach einem der Ansprüche 1 bis 4, ***dadurch gekennzeichnet, dass*** die Referenzmesswerte von Referenzmesseinheiten (R1, R2, R3) erstellt werden, wobei die Phasenzugehörigkeit der einzelnen Referenzmesswerte bekannt ist (106).

5. Verfahren nach Anspruch 4, ***dadurch gekennzeichnet, dass*** die Referenzmesseinheiten (R1, R2, R3) in unterschiedlichen Strängen (L1, L2, L3) des Niederspannungsnetzes (NN) installiert werden.

6. Verfahren nach einem der vorangegangenen Ansprüche, ***dadurch gekennzeichnet, dass*** als Klassifikatoren sogenannte Support Vector Machines eingesetzt werden (106).

7. Verfahren nach einem der vorangegangenen Ansprüche, ***dadurch gekennzeichnet, dass*** als Messwerte von im Niederspannungsnetz (NN) installierten Messeinheiten (M1-M7) phasenspezifisch gemessene Spannungswerte, Wirk- und/oder Blindleistungswerte verwendet werden.

8. Verfahren nach einem der vorangegangenen Ansprüche, ***dadurch gekennzeichnet, dass*** eine periodische oder kontinuierliche Durchführung vorgesehen wird.

## Claims

1. Method for the automatic phase detection of measurement values which are measured phase-specifically by measuring units (M1-M7) installed in a multiphase low-voltage network (NN), provided with a time stamp and routed to at least one data concentration unit (DK) on a regular basis, ***characterised in that*** for a predefinable observation period the measurement values of the measuring units (M1-M7) are collected (102), that the predefinable observation period is subdivided into a plurality of time segments to which the respective measurement values are assigned (105) based on their time stamp, that based on reference measurement values for each of the time segments an independent classifier is generated (106), and that based on the respective independent classifier the corresponding phases are assigned (107) to the measurement values of the respective segment.

2. Method according to claim 1, ***characterised in that*** for temporally unsynchronised measurement values present a temporal synchronisation of the measurement values for the respective measuring units (M1-M7) is first performed (103, 104).

3. Method according to one of claims 1 to 2, ***characterised in that*** for each measurement value the phases assigned to the different segments are combined, and that then a frequency of the assignment of the respective phases to the respective measurement value is evaluated (108).

4. Method according to one of claims 1 to 4, ***characterised in that*** the reference measurement values of reference measuring units (R1, R2, R3) are created, wherein the phase membership of the individual reference measurement values is known (106).

5. Method according to claim 4, ***characterised in that*** the reference measuring units (R1, R2, R3) are installed in different phase elements (L1, L2, L3) of the low-voltage network (NN).

6. Method according to one of the preceding claims, ***characterised in that*** so-called support vector machines are used as classifiers (106).

7. Method according to one of the preceding claims, ***characterised in that*** phase-specifically measured voltage values, active and/or reactive power values are used as measurement values of measuring units (M1-M7) installed in the low-voltage network (NN).

8. Method according to one of the preceding claims, ***characterised in that*** a periodic or continuous implementation is provided.

## Revendications

1. Procédé de détection automatique de phase de valeurs mesurées, qui sont mesurées de manière spécifique en phase par des unités de mesure (M1-M7) installées dans un réseau basse tension polyphasé, qui sont dotées d'une estampille temporelle et sont transmises régulièrement à au moins une unité de concentration de données (DK),
**caractérisé en ce que** les valeurs mesurées par des unités de mesure (M1-M7) sont collectées (102) pour une période d'observation prédéterminée, **en ce que** la période d'observation prédéterminée est divisée en plusieurs plages de temps, auxquelles les valeurs mesurées respectives sont attribuées (105) sur la base de l'estampille temporelle, **en ce qu'**un classifieur indépendant est généré (106) sur la base de valeurs mesurées de référence pour chacune des plages de temps et **en ce que** les phases correspondantes sont attribuées (107) aux valeurs mesurées de la plage de temps respective sur la base du classifieur indépendant respectif.

2. Procédé selon la revendication 1, **caractérisé en ce qu'**en présence de valeurs mesurées qui sont non synchronisées temporellement, une synchronisation temporelle des valeurs mesurées pour les unités de mesure respectives (M1-M7) est d'abord effectuée (103, 104).

3. Procédé selon la revendication 1 ou 2, **caractérisé en ce que**, pour chaque valeur mesurée, les phases attribuées pour les différentes plages de temps sont combinées, et **en ce qu'**ensuite, une fréquence de l'attribution des phases respectives à la valeur mesurée respective est évaluée (108).

4. Procédé selon l'une des revendications 1 à 3, **caractérisé en ce que** les valeurs de mesure de référence sont établies par des unités de mesure de référence (R1, R2, R3), et dans lequel l'appartenance à une phase des différentes valeurs de mesure de référence est connue (106).

5. Procédé selon la revendication 4, **caractérisé en ce que** les unités de mesure de référence (R1, R2, R3) sont installées dans différents conducteurs (L1, L2, L3) du réseau basse tension (NN).

6. Procédé selon l'une des revendications précédentes, **caractérisé en ce qu'**en tant que classifieurs, on utilise (106) ce que l'on nomme des machines à vecteurs de support.

7. Procédé selon l'une des revendications précédentes, **caractérisé en ce que** les valeurs mesurées sont des valeurs de tension, des valeurs de puissance active et/ou de puissance réactive mesurées de façon spécifique en phase par des unités de mesure (M1-M7) installées dans le réseau basse tension (NN).

8. Procédé selon l'une des revendications précédentes, **caractérisé en ce qu'**il est prévu d'être exécuté de façon périodique ou continue.
